# EUROPEAN PATENT SPECIFICATION

(11) **EP 1 973 145 B1**
(45) Date of publication and mention of the grant of the patent: **03.03.2010**
(21) Application number: 08152966.1
(22) Date of filing: 19.03.2008
(51) Int. Cl.: H01L 21/00, C23C 14/56, B05D 5/12

(54) **Apparatus and method for depositing protective layer**
Vorrichtung und Verfahren zum Abscheiden einer Schutzschicht
Appareil et procédé de dépôt d'une couche protectrice

(30) Priority: 22.03.2007 KR 20070028236
(43) Date of publication of application: 24.09.2008
(73) Proprietor: Samsung SDI Co., Ltd., Suwon-si Gyeonggi-do (KR)
(72) Inventor: Choi, Yong-Sup, Gyeonggi-do (KR); Kim, Jin-Pil, Gyeonggi-do (KR); Lee, Kang-Il, Gyeonggi-do (KR)
(74) Representative: Hengelhaupt, Jürgen

(56) References cited:
- JP-A- 2005 206 852
- US-A- 4 643 629
- US-B1- 6 455 101

## Description

### Field of the Invention

The present invention relates to an apparatus for depositing a protective layer, and more particularly, to an apparatus for depositing a protective layer, which can prevent moisture inflow while depositing a protective layer on a substrate and can easily ventilate moisture, and a depositing method using the apparatus.

### Description of the Related Art

Generally, a plasma display panel denotes a flat display device, wherein a plurality of discharge electrodes is formed between a plurality of substrates. Discharge gas is injected into a sealed discharge space between the substrates, and predetermined power is supplied to each discharge electrode. Accordingly, an image is realized by using light emitted by exciting a phosphoric material of a phosphor layer by using ultraviolet rays generated in the discharge space.

Processes of manufacturing a plasma display panel will now be described.

In the case of a first substrate, a first discharge electrode is formed on the first substrate, a first dielectric layer is printed so as to embed the first discharge electrode, and a protective layer is formed on the surface of the first dielectric layer. In the case of a second substrate, a second discharge electrode is formed on the second substrate, a second dielectric layer is printed so as to embed the second discharge electrode, barrier ribs are formed to divide discharge cells on the second dielectric layer, and red, green, and blue phosphor layers are coated on the inner surface of the barrier ribs.

Then, the first and second substrates are mutually aligned, and glass frit is coated on the facing inner boundaries of the first and second substrates. Accordingly, the first and second substrates are sealed together through a process of heat treatment at a predetermined temperature. In order to remove impurities, including moisture, which remains between the sealed first and second substrates, ventilation is performed in a vacuum. Next, a discharge gas, containing Xe-Ne as the main components, is injected between the first and second substrates, a predetermined power is supplied to the plasma display panel for aging discharge, and then an IC chip is installed. Thus, the plasma display panel is manufactured.

Here, the protective layer is formed of a material having a high secondary electron emission coefficient, such as MgO, and thus emits secondary electrons. Accordingly, the plasma display panel is induced to discharge gas at a low voltage.

With contemporary practice for depositing a protective layer, often some of the MgO raw material is also deposited on the carrier, which supports the substrate. Then, when an MgO thin film is exposed to moisture, the MgO thin film easily combines, physically or chemically, with the moisture. If the moisture, which is absorbed in the carrier, is discharged, the moisture changes an environment of the apparatus, and thus deteriorates the characteristics of the thin film. Also, as the carrier is exposed to the atmosphere, the characteristics of the thin film deteriorate due to moisture pressure.

In order to solve these problems, the carrier may be transferred only in a vacuum chamber, rather than being exposed to the atmosphere. When the carrier is transferred in a vacuum, these problems caused by moisture absorption by the raw MgO adhering to the carrier can be prevented, however the necessity of installing and removing the substrate while the carrier in a vacuum, is complicated.

In more recent efforts, a large-sized substrate is mounted on the carrier, and a deposition side of the substrate is covered by a mask in order to manufacture panels of a desired size. Rollers are used to transfer the substrate to a carrier return chamber. The rollers contact boundaries of the substrate and a part covered by the mask; the distances between the rollers and locations of the rollers are frequently changed, and thus the locations of the rollers should be rearranged in order to change the type of panel. In order to rearrange the distances of the rollers, the vacuum is lost and additional time is required in order to set conditions for depositing a protective layer. Accordingly, productivity of panels is substantially limited.

Reference is also made to prior art document US-A-6, 455,101.

It is therefore, an object of the present invention to provide an improved method and an improved process for depositing a protective layer on a substrate.

It is another object to provide a method and apparatus for depositing onto a substrate, a protective layer that is able to easily ventilate moisture while prevent moisture inflow.

### SUMMARY OF THE INVENTION

The present invention provides an apparatus for depositing a protective layer according to claim 1, which can prevent a carrier from being exposed to external moisture by forming a chamber in a substrate loading part of the carrier, where a substrate is mounted, so as to form a nitrogenous or clean dry atmosphere and maintaining positive pressure, and a depositing method using the apparatus.

According to an aspect of the present invention, there is provided an apparatus for depositing a protective layer. The apparatus including: an anti-hydration module having a substrate input hole through which a substrate is loadable and which provides a space for mounting the substrate on a carrier; a load lock chamber, which is connected to the anti-hydration module and adapted for maintaining a vacuum; a plurality of vacuum chambers, which are connected to the load lock chamber; a depositing chamber, which is installed between two of the vacuum chambers; a target unit, which is installed in the depositing chamber and adapted for depositing a raw material of a protective layer on the substrate; a transferring unit which is continuously installed in the anti-hydration module, the load lock chamber, the vacuum chambers, and the depositing chamber, and adapted for transferring the substrate mounted on the carrier; and gate valves, which are installed in boundaries of the anti-hydration module, the load lock chamber, the vacuum chambers, and the deposition chamber, and are adapted for selectively open or close each of the anti-hydration module, the load lock chamber, the vacuum chambers, and the deposition chamber.

The anti-hydration module may be adapted for providing an inert atmosphere or clean dry air.

The apparatus may further include a slit, which is formed between the substrate input hole and the anti-hydration module, is adapted for being selectively opened or closed by a door, and provides a passage through which the substrate is transferable.

Some vacuum chambers and the depositing chamber may be divided into upper and bottom parts by a top and bottom separator.

Heaters for heating up the substrate may be installed in some vacuum chambers and the depositing chamber.

The target unit may comprises a plasma or electron beam source and a hearth.

The transferring unit may include carrier rollers which are adapted for transfer the carrier, and substrate rollers which are adapted for transfer the substrate.

The carrier rollers may be continuously located in the anti-hydration module, the load lock chamber, the vacuum chambers, and the depositing chamber.

The substrate rollers may be installed inside the anti-hydration module.

The anti-hydration module may comprises a top and bottom transferring unit, which is adapted for lifting and lowering the carrier rollers and the substrate rollers.

According to another aspect of the present invention according to claim 10, there is provided a method of depositing a protective layer, the method including: loading a substrate through a substrate input hole to an anti-hydration module; mounting the loaded substrate on a carrier by using a top and bottom transferring unit; transferring the substrate, mounted on the carrier, to a load lock chamber; passing the substrate, mounted on the carrier, through a plurality of vacuum chambers; depositing a protective layer on the substrate by using a target unit of an depositing chamber between the vacuum chambers; and picking up the substrate, in which the protective layer is deposited, after the substrate passes through the vacuum chambers, the load lock chamber, and the anti-hydration module.

The substrate may be loaded into the anti-hydration module through a slit, which is installed between the substrate input hole and the anti-hydration module.

The mounting of the substrate on the carrier may include: raising the carrier, which is supported by carrier rollers, towards the substrate; seating an upper surface of the carrier on a bottom boundary surface of the substrate; separating substrate rollers, which support the substrate, from the substrate by lowering the substrate rollers; and transferring the carrier, in which the substrate is mounted, by using the carrier rollers.

The mounting of the substrate on the carrier could be done directly by robot through a slit.

The anti-hydration module may maintain an inert atmosphere.

The method may further comprise adjusting pressure of the load lock chamber correspondingly to pressure of an adjacently connected vacuum chamber by closing a gate valve after the substrate, mounted on the carrier, is transferred.

The method may further comprise depositing moisture of the substrate, mounted on the carrier, while the substrate passes through some vacuum chambers and the depositing chamber, installed between the vacuum chambers, by heating heaters installed inside the some vacuum chambers and the depositing chamber. The method may further comprise discharging moisture, which is deposited from the substrate mounted on the carrier and passing through an upper part of the some chambers and the depositing chamber, by installing a top and bottom separator in the some chambers and the depositing chamber.

Moisture may be removed using a vacuum from said substrate and said carrier and thus is prevented from accumulating in said depositing chamber.

The method may further include discharging moisture, which is deposited from the substrate mounted on the carrier and passing through an upper part of the some chambers and the depositing chamber, by installing a top and bottom separator in the some chambers and the depositing chamber.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:
FIG. 1 is a diagram illustrating a contemporary apparatus for depositing a protective layer;
FIG. 2 is a diagram illustrating another contemporary apparatus for depositing a protective layer;
FIG. 3 is a plan view illustrating a contemporary substrate mounted on a carrier;
FIG. 4 is a diagram illustrating another contemporary apparatus for depositing a protective layer;
FIG. 5 is a diagram illustrating an apparatus for depositing a protective layer according to an embodiment of the present invention;
FIGS. 6A, 6B, and 6C are enlarged diagrams illustrating A of FIG. 5 according to embodiments of the present invention;
FIG. 7A is a cross-sectional view illustrating a carrier of FIG. 5 before a substrate is mounted; and
FIG. 7B is a cross-sectional view illustrating a carrier of FIG. 7A after a substrate is mounted.

### DETAILED DESCRIPTION OF THE INVENTION

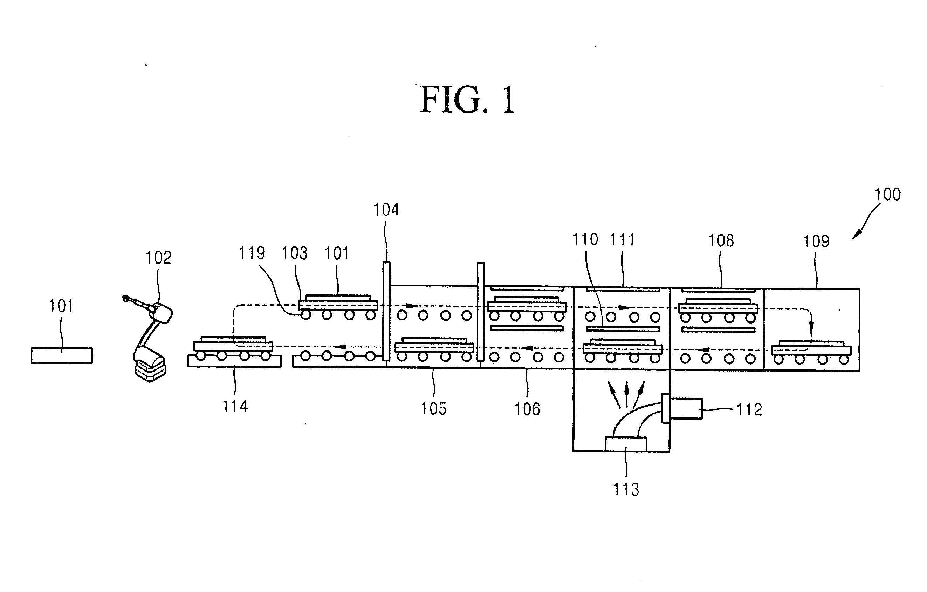

Turning now to the drawings, FIG. 1 is a diagram illustrating a contemporary apparatus 100 for depositing a protective layer.

Referring to FIG. 1, a substrate 101 is mounted on a carrier 103 by a robot 102.

The substrate 101, mounted on the carrier 103, is loaded into a load lock chamber 105 as a first gate valve 104 opens. At this time, the carrier 103 is transferred as rollers 119 roll.

The substrate 101, which is mounted on the carrier 103 loaded into the load lock chamber 105, is transferred to a buffer unit-1 chamber 106. While the substrate 101 is transferred from the buffer unit-1 chamber 106, to an upper part of a deposition chamber 111, to a buffer unit-2 chamber 108, and then to a return chamber 109, the substrate 101 is heated to a processing temperature by a heater 110.

An MgO raw material is deposited on the substrate 101, which is mounted on the carrier 103, as the substrate 101 is transferred from the bottom part of the return chamber 109, to the bottom part of the buffer unit-2 chamber 108, and then to the bottom part of the deposition chamber 111. MgO particles deposited on the substrate 101 are evaporated by melting a MgO raw material on a hearth 113 by using a plasma or electron beam source 112.

Then, the substrate 101 is transferred from the bottom part of the buffer unit-1 chamber 106, the load lock chamber 105, and to a substrate pickup and loading platform 114. Accordingly, the substrate 101 is picked up by the robot 102.

However, while depositing the MgO raw material on the substrate 101, some of the MgO raw material is also deposited on the carrier 103, which supports the substrate 101. When an MgO thin film is exposed to moisture, the MgO thin film easily combines, physically or chemically, with the moisture. If the moisture, which is absorbed in the carrier 103, is discharged in the apparatus 100, the moisture changes an environment of the apparatus 100, and thus deteriorates the characteristics of the MgO thin film. Also, as the carrier 103 is exposed to the atmosphere, the characteristics of the MgO thin film deteriorate due to moisture pressure.

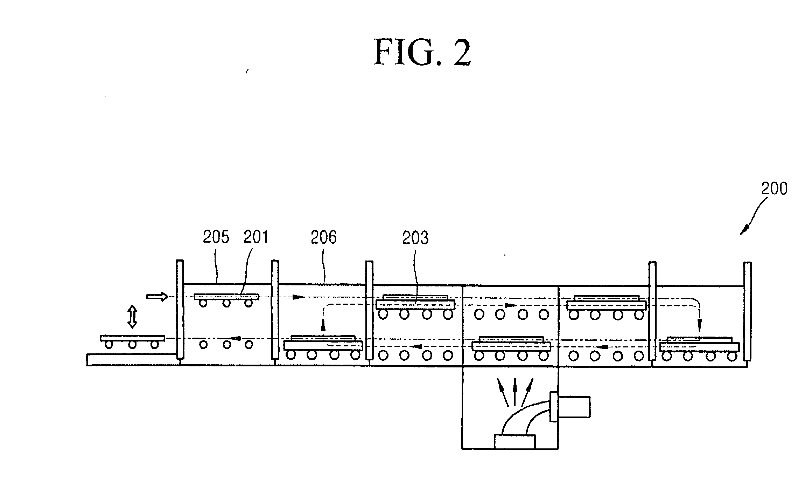

In order to solve the above problem, an apparatus 200 for depositing a protective layer, which uses a transfer only substrate system (TOSS) of Anelva Corp. in Japan, as illustrated in FIG. 2 is used. According to the apparatus 200, a carrier 203 is transferred only in a vacuum chamber, and is not exposed to the atmosphere.

Referring to FIG. 2, a substrate 201, which is loaded into a load lock chamber 205, is mounted on the carrier 203 in a carrier return chamber 206. Before a new substrate 201 is mounted on the carrier 203, a pre-mounted substrate 201 is transferred from the bottom part of the carrier return chamber 206 to the load lock chamber 205. Then, the carrier 203, without any substrate, is transferred to an upper part of the carrier return chamber 206 so that the new substrate 201 can be mounted.

According to the TOSS, since the carrier 203 can be transferred in a vacuum, problems of moisture absorption by MgO adhering to the carrier 203 can be prevented. However, since the substrate 201 and the carrier 203 should be attached and detached in a vacuum, substrate transference is complicated.

Recently, a multi separated panel method has been applied to a substrate for a panel, wherein a large substrate is divided into panels of a desired size.

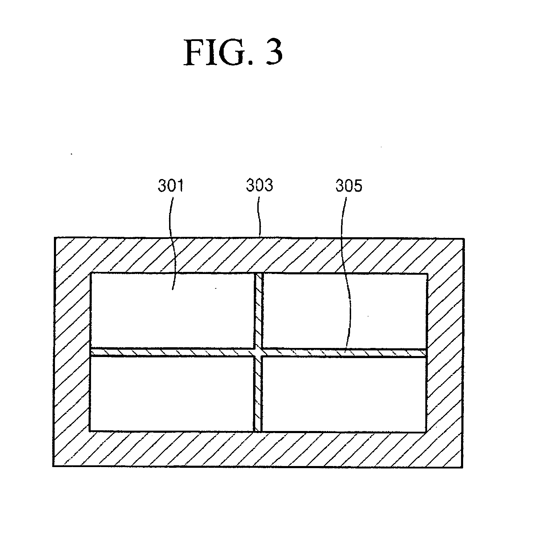

FIG. 3 is a plan view illustrating a contemporary substrate 301 for a multi separated panel, a carrier 303, and a mask 305.

Referring to FIG. 3, the large-sized substrate 301 is mounted on the carrier 303, and a deposition side of the substrate 301 is covered by the mask 305 in order to manufacture panels of a desired size. In an apparatus for depositing a protective layer, which uses the TOSS in a similar manner as used by the apparatus 200 of FIG. 2, rollers are used to transfer the substrate 301 to a carrier return chamber 206.

Here, parts that the substrate 301 and the rollers contact are boundaries of the substrate 301 and a part covered by the mask 305. In order to manufacture panels of various sizes by using the apparatus, distances between the rollers and locations of the rollers should change. If the substrate 301 is transferred after being mounted on the carrier 303, a roller distance problem does not occur, but in the case of the TOSS, only the substrate 301 is transferred to the carrier return chamber 206 of FIG. 2, and thus the locations of the rollers should be rearranged in order to change the type of panel. In order to rearrange the distances of the rollers, a vacuum should be removed and a lot of time is required in order to set conditions for depositing a protective layer. Accordingly, productivity of panels may deteriorate.

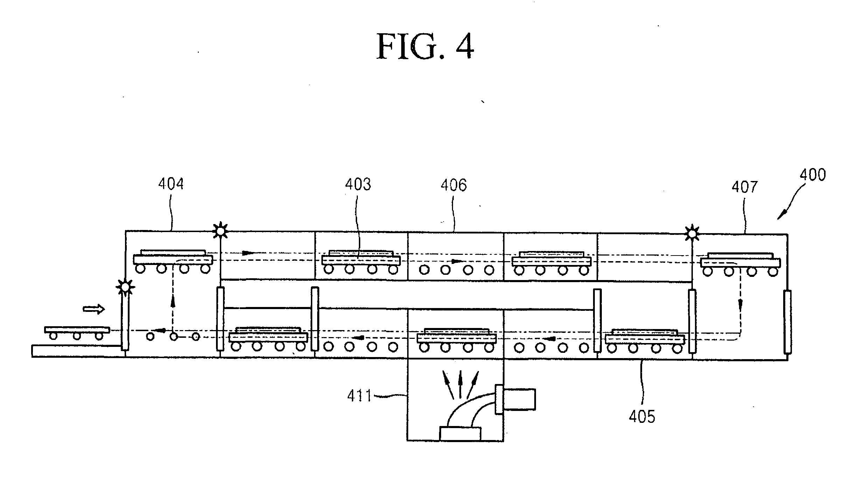

In the case of an apparatus 400 for depositing a protective layer, which uses a clean dry air (CDA) method of UIVA in Japan, illustrated in FIG. 4, attaching and detaching a substrate 401 and a carrier 403 are performed in a substrate pickup and loading platform 404, which is managed with dry air, instead of a vacuum as with the TOSS. The newly mounted substrate 401 is transferred to a carrier vacuum loading chamber 407 through a CDA passage 406, and then is loaded into a depositing chamber 411 through a load lock chamber 405.

The CDA method is advantageous in terms of changing the type of panel compared to the TOSS, but cannot completely prevent the carrier 403, wherein MgO is adhered, from contacting the atmosphere. Accordingly, the depositing chamber 411 cannot manage impurities better than an depositing chamber using the TOSS. Also, it is costly to keep the air of the CDA passage 405 dry.

Hereinafter, the present invention will be described more fully with reference to the accompanying drawings, in which exemplary embodiments of the invention are shown.

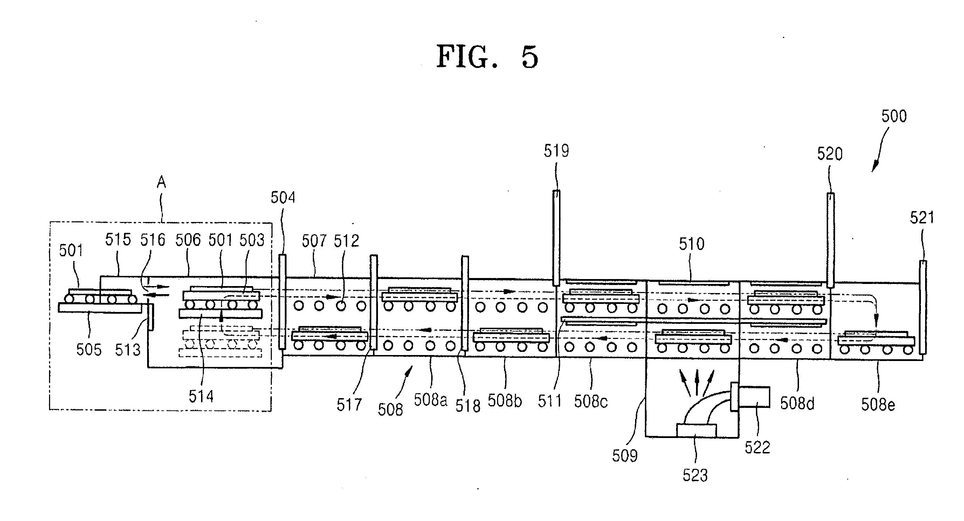

FIG. 5 is a diagram illustrating an apparatus 500 for depositing a protective layer according to an embodiment of the present invention.

Referring to FIG. 5, the apparatus 500 includes an anti-hydration module 506, a load lock chamber 507 connected to the anti-hydration module 506, a plurality of vacuum chambers 508 connected to the load lock chamber 507, and an depositing chamber 509 installed inside the vacuum chambers 508.

A substrate input hole 515, to which a substrate 501 on a substrate input unit 505 is transferred, is formed in a separate chamber in front of the anti-hydration module 506. The substrate input hole 515 is connected to the anti-hydration module 506 through a slit 516. The substrate input hole 515 can minimize the amount of inert gas, clean dry air or nitrogen consumed in the anti-hydration module 506 since the substrate input hole 515 is combined to an upper part of the anti-hydration module 506, which maintains an inert atmosphere.

The slit 516 is formed in the smallest size possible that the substrate 501 on the substrate input unit 505 can be loaded into, and maintains positive pressure inside the anti-hydration module 506. A door 513 is installed in the slit 516 so that the slit 516 can be selectively opened or closed. The door 513 opens when the substrate 501 is loaded and closes at other times. Accordingly, loss of inert gas clean dry air, or nitrogen inside the anti-hydration module 506 can be prevented.

Inert gas, such as nitrogen, is injected into the anti-hydration module 506. Accordingly, the internal anti-hydration module 506 maintains an atmosphere of inert gas, and thus moisture pressure does not exist.

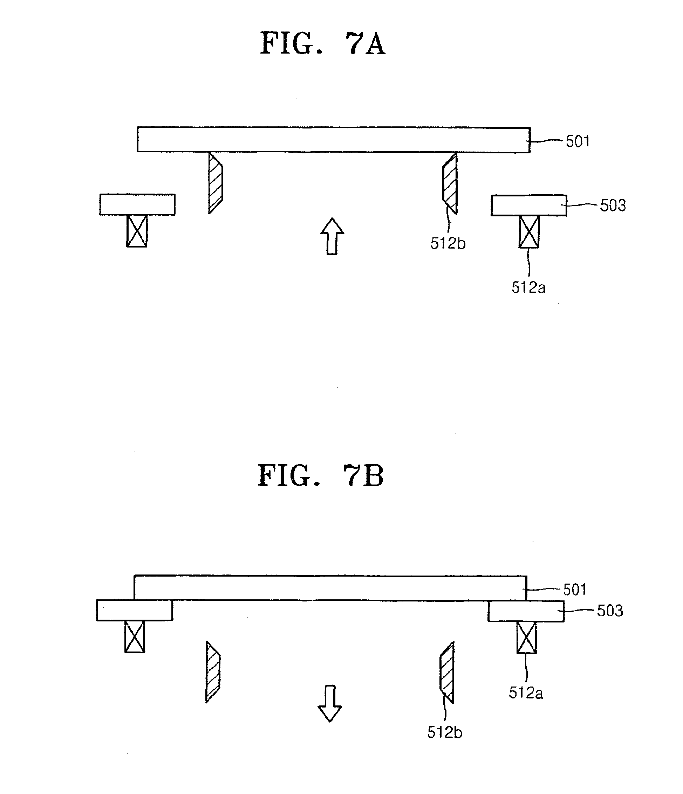

Rollers 512, which transfer the substrate 501 mounted on a carrier 503, are installed inside the anti-hydration module 506, the load lock chamber 507, the plurality of vacuum chambers 508, and the depositing chamber 509. The rollers 512 include carrier rollers 512a and substrate rollers 512b as illustrated in FIG. 7A. The carrier rollers 512a roll in an endless track inside the anti-hydration module 506, the load lock chamber 507, the vacuum chambers 508, and the depositing chamber 509. The substrate rollers 512b are used to mount the substrate 501, which is loaded from the substrate input hole 515, on the carrier 503 in the anti-hydration module 506.

The anti-hydration module 506 includes a top and bottom transferring unit 514, which lifts and lowers the carrier rollers 512a and the substrate rollers 512b. A structure of the top and bottom transferring unit 514 is not limited as long as the structure can lift and lower the carrier rollers 512a and the substrate rollers 512b by using elevating means, such as a hydraulic cylinder. In the anti-hydration module 506, the carrier 503 can be removed from the substrate 501 by using the carrier rollers 512a, the substrate rollers 512b and the top and bottom transferring unit 514.

A first gate valve 504 is installed between the anti-hydration module 506 and the load lock chamber 507. A second gate valve 517 is installed between the load lock chamber 507 and the vacuum chamber 508. Accordingly, after the substrate 501, mounted on the carrier 503 is loaded into the load lock chamber 507, the first and second gate valves 504 and 517 occlude the load lock chamber 507 so that the pressure inside the load lock chamber 507 is similar to the pressure inside the vacuum chamber 508.

The vacuum chamber 508 is divided into a first chamber 508a, a second chamber 508b, a third chamber 508c, a fourth chamber 508d, and a fifth chamber 508e by installing a plurality of gate valves, which are a third gate valve 518, a fourth gate valve 519, a fifth gate valve 520, and a sixth gate value 521. The vacuum chamber 508 can gradually maintain the vacuum by being divided into the plurality of chambers 508a through 508e. When there is disorder in one chamber, the chamber can be easily repaired by occluding the chamber by using corresponding gate valves.

A depositing chamber 509 is installed between the third chamber 508c and the fourth chamber 508d. A plurality of heaters 510 are installed in the third chamber 508c, the depositing chamber 509, and the fourth chamber 508d. The substrate 501 mounted on the carrier 503 inserted through the anti-hydration module 506 is heated by the heaters 510.

The contemporary apparatuses 100, 200, and 400 of FIGS. 1, 2, and 4 increase the moisture pressure inside a depositing chamber by emitting moisture adsorbed in a carrier and a substrate during heating. The moisture pressure increases since the emitted moisture is emitted through a vacuum pump below the depositing chamber.

In the current embodiment, since a top and bottom separator 511, which separates the depositing chamber 509, is installed, a vacuum is separately pumped to the top and bottom transferring unit 514. In this case, the moisture emitted from the substrate 501 or the carrier 503 is not moved to the bottom of the depositing chamber 509 but is ventilated, and thus the moisture pressure inside the depositing chamber 509 is not increased. The heaters 510 are each installed in the upper and lower parts divided by the top and bottom separator 511, and the heaters 510 can be used instead of the top and bottom separator 511.

A target unit, such as a plasma or electron beam source 522, is installed in the depositing chamber 509 in order to form a protective layer on the substrate 501 and a hearth 523 is installed near the plasma or electron beam source 522. Accordingly, the raw material of the protective layer, such as MgO, which is deposited on the substrate 501, can be melted on the hearth 523 and deposited by the plasma or electron beam source 522.

Operations of the apparatus 500 of the current embodiment will now be described with reference to FIGS. 5, 6A through 6C, 7A, and 7B.

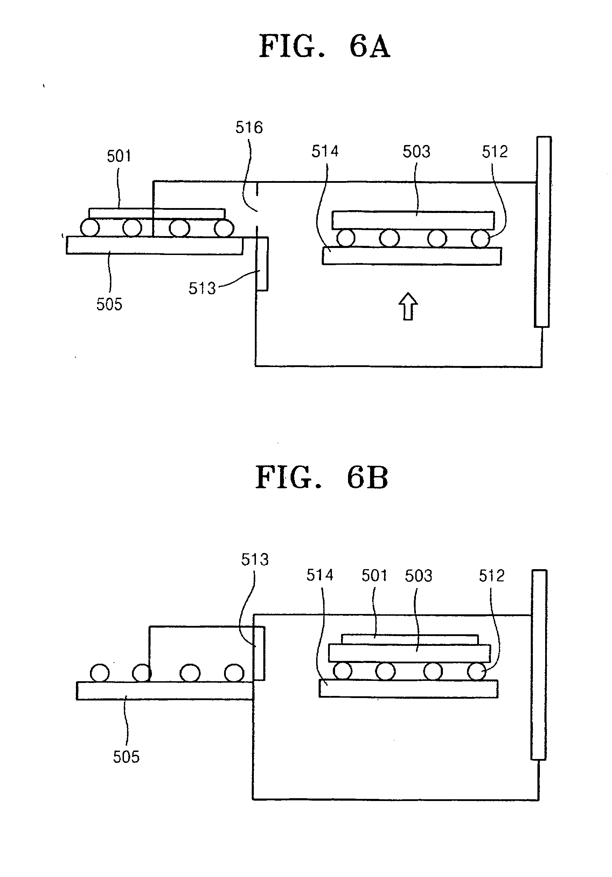

First, as illustrated in FIG. 6A, the substrate 501 is loaded into the substrate input hole 515 through the slit 516. Here, since the carrier 503 is not exported to the substrate input hole 515, only the substrate 501 is transferred. The carrier 503 on the rollers 512 rises by the top and bottom transferring unit 514 in the anti-hydration module 506.

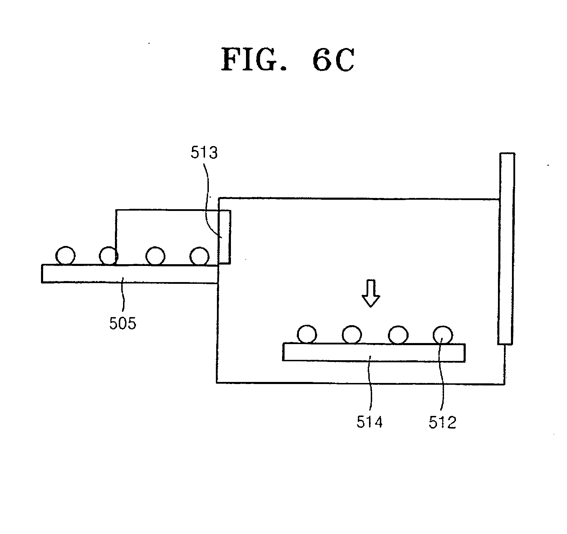

Next, as illustrated in FIG. 6B, the substrate 501, which is loaded through the substrate input hole 515, is mounted on the carrier 503. After the substrate 501 is loaded into the anti-hydration module 506, the slit 516 is sealed by the door 513, and thus the internal anti-hydration module 506 maintains the positive pressure. When the substrate 501, mounted on the carrier 503 enters the load lock chamber 507, the top and bottom transferring unit 514 descends as illustrated in FIG. 6C.

FIG. 7A illustrates a process of mounting the substrate 501 on the carrier 503. When the substrate 501, while being supported on the substrate rollers 512b, is loaded into the anti-hydration module 506 through the slit 516, the carrier rollers 512a, which support the carrier 503, ascend by the top and bottom transferring unit 514.

Here, the carrier 503 is in a square frame shape and the substrate 501 is formed of a board-shaped glass. Accordingly the bottom surface of the substrate 501 is supported by the substrate rollers 512b and the bottom surface of the carrier 503 is supported by the carrier rollers 512a, and thus the substrate 501 and the carrier 503 can separately operate.

Then, as illustrated in FIG. 7B, the bottom surface of the substrate 501, transferred by the substrate rollers 512b, is seated on the top surface of the carrier 503, which is supported by the ascended carrier rollers 512a. When the substrate 501 is seated on the carrier 503, the substrate rollers 512b are descended to the bottom part of the anti-hydration module 506 by the top and bottom transferring unit 514.

Accordingly, the substrate 501 is mounted on the carrier 503, and the carrier 503 is transferred to the load lock chamber 507 by the carrier rollers 512a. Also, the substrate rollers 512b move up and down only inside the anti-hydration module 506.

Then, the first gate valve 504 is opened, and the substrate 501 mounted on the carrier 503 is transferred to the load lock chamber 507 as the carrier rollers 512a rotate. Here, the pressure inside the load lock chamber 507 is adjusted to be equal to the pressure inside the first vacuum chamber 508a by using a vacuum pump.

Next, the second gate valve 517 is opened, and the substrate 501 mounted on the carrier 503 passes the first vacuum chamber 508a, the second vacuum chamber 508b, the upper parts of the third vacuum chamber 508c, the depositing chamber 509, and the fourth vacuum chamber 508d, which are divided by the top and bottom separator 511.

Here, the heaters 510 are installed in the upper parts of the third vacuum chamber 508c, the depositing chamber 509, and the fourth vacuum chamber 508d, and thus the heater 501, mounted on the carrier 503, emits moisture by being heated by the heaters 510. The heating temperature of the heaters 510 is approximately between 100 to 400°C, and preferably approximately 250°C. The emitted moisture is quickly exhausted from the upper parts of the third vacuum chamber 508c, the depositing chamber 509, and the fourth vacuum chamber 508d by using a separate vacuum pump.

The substrate 501, mounted on the carrier 503, passes through and is returned in the fifth chamber 508e, and then passes through the bottom parts of the fourth chamber 508d and the depositing chamber 509.

When the substrate 501, mounted on the carrier 503, is transferred to the bottom part of the depositing chamber 509, the raw material of the protective layer is deposited on the substrate 501. Particles of the protective layer, such as MgO, deposited on the substrate 501 are deposited by melting the raw material on the hearth 523 by using the plasma or electron beam source 522.

Then, the substrate 501, mounted on the carrier 503, is transferred to the bottom part of the third chamber 508c, the second chamber 508b, and the first chamber 508a. When the second gate valve 517 opens, the substrate 501, mounted on the carrier 503, is then transferred to the load lock chamber 507. After a predetermined cooling time, the substrate 501, mounted on the carrier 503, is transferred to the anti-hydration module 506 as the first gate valve 504 opens.

The substrate 501, mounted on the carrier 503, is transferred to the upper part of the anti-hydration module 506 by the top and bottom transferring unit 514 according to the interaction of the carrier rollers 512a and the substrate rollers 512b. Then, the door 513 opens the slit 506, and the substrate 501 is picked up and loaded to the substrate input hole 515 by the substrate rollers 512b.

As described above, the following effects can be obtained by using the method and apparatus of the present invention.

First, since a carrier is not exposed to the atmosphere, the moisture pressure inside an depositing chamber does not increase even if the carrier is used for a long time. Accordingly, a uniform quality of a deposited protective layer can be achieved.

Second, since the moisture pressure inside the depositing chamber does not increase after a predetermined time, the carrier can be maintained for a long time, and thus productivity of the carrier can be improved.

## Claims

1. An apparatus (500) for depositing a protective layer, the apparatus (500) comprising:
an anti-hydration module (506) having a substrate input hole (515) through which a substrate (501) is loadable and which provides a space for mounting the substrate (501) on a carrier (503);
a load lock chamber (507), which is connected to the anti-hydration module (506) and adapted for maintaining a vacuum;
a plurality of vacuum chambers (508a...508e), which are connected to the load lock chamber (507);
a depositing chamber (509), which is installed between two of the vacuum chambers (508c, 508d);
a target unit, which is installed in the depositing chamber (509) and is adapted for depositing a raw material of a protective layer on the substrate (501);
a transferring unit which is continuously installed in the anti-hydration module (506), the load lock chamber (507), the vacuum chambers (508a...508e), and the depositing chamber (509), and adapted for transfer of the substrate (501) mounted on the carrier (503); and
gate valves (504, 517...520), which are installed in boundaries of the anti-hydration module (506), the load lock chamber (507), the vacuum chambers (508a...508e), and the deposition chamber (509), and are adapted for selectively open or close each of the anti-hydration module (506), the load lock chamber (507), the vacuum chambers (508a...508e), and the deposition chamber (509), **characterized in that**
the anti-hydration module (506) is formed to maintain an atmosphere of inert gas.

2. The apparatus of claim 1, further comprising a slit (516), which is formed between the substrate input hole (515) and the anti-hydration module (506), is adapted for being selectively opened or closed by a door (513), and provides a passage through which the substrate (501) is transferrable.

3. The apparatus of any of the preceding claims, wherein some vacuum chambers (508c, 508d) and the depositing chamber (509) are divided into upper and bottom parts by a top and bottom separator (511).

4. The apparatus of claim 3, wherein heaters (510) for heating up the substrate (501) are installed in some vacuum chambers (508c, 508d) and the depositing chamber (509).

5. The apparatus of any of the preceding claims, wherein the target unit comprises a plasma or electron beam source (522) and a hearth (523).

6. The apparatus of any of the preceding claims, wherein the transferring unit comprises carrier rollers (512a) which are adapted for transferring the carrier (503), and substrate rollers (512b) which are adapted for transferring the substrate (501).

7. The apparatus of claim 6, wherein the carrier rollers (512a) are continuously located in the anti-hydration module (506), the load lock chamber (507), the vacuum chambers (508a...508e), and the depositing chamber (509).

8. The apparatus of claims 6 or 7, wherein the substrate rollers (512b) are installed inside the anti-hydration module (506).

9. The apparatus of claim 8, wherein the anti-hydration module (506) comprises a top and bottom transferring unit (514), which is adapted for lifting and lowering the carrier rollers (512a) and the substrate rollers (512b).

10. A method of depositing a protective layer, the method comprising:
loading a substrate (501) through a substrate input hole (515) to an anti-hydration module (506);
mounting the loaded substrate (501) on a carrier (503) by using a top and bottom transferring unit (514);
transferring the substrate (501), mounted on the carrier (503), to a load lock chamber (507);
passing the substrate (501), mounted on the carrier (503), through a plurality of vacuum chambers (508a...508e);
depositing a protective layer on the substrate (501) by using a target unit of an depositing chamber (509) between the vacuum chambers (508a...508e); and
picking up the substrate (501), in which the protective layer is deposited, after the substrate (501) passes through the vacuum chambers (508a...508e), the load lock chamber (507), and the anti-hydration module (506),
wherein the internal anti-hydration module (506) maintains an atmosphere of inert gas.

11. The method of claim 10, wherein the substrate (501) is loaded into the anti-hydration module (506) through a slit (516), which is installed between the substrate input hole (515) and the anti-hydration module (506).

12. The method of claims 10 or 11, wherein the mounting of the substrate (501) on the carrier (503) comprises:
raising the carrier (503), which is supported by carrier rollers (512a), towards the substrate (501);
seating an upper surface of the carrier (503) on a bottom boundary surface of the substrate (501);
separating substrate rollers (512b), which support the substrate (501), from the substrate (501) by lowering the substrate rollers (512b); and
transferring the carrier (503), in which the substrate (501) is mounted, by using the carrier rollers (512a).

13. The method of any of claims 10 to 12, further comprising adjusting pressure of the load lock chamber (507) correspondingly to pressure of an adjacently connected vacuum chamber (508a) by closing a gate valve (504) after the substrate (501), mounted on the carrier (503), is transferred.

14. The method of any of claims 10 to 13, further comprising depositing moisture of the substrate (501), mounted on the carrier (503), while the substrate (501) passes through some vacuum chambers (508c, 508d) and the depositing chamber (509), installed between the vacuum chambers (508a...508e), by heating heaters (510) installed inside the some vacuum chambers (508c, 508d) and the depositing chamber (509).

15. The method of claim 14, further comprising discharging moisture, which is deposited from the substrate (501) mounted on the carrier (503) and passing through an upper part of the some chambers (508c, 508d) and the depositing chamber (509), by installing a top and bottom separator (511) in the some chambers (508c, 508d) and the depositing chamber (509).

16. The method of any of claims 10 to 15, wherein moisture is removed using a vacuum from said substrate (501) and said carrier (503).

## Patentansprüche

1. Eine Vorrichtung (500) zum Abscheiden einer Schutzschicht, wobei die Vorrichtung (500) Folgendes umfasst:
ein Anti-Hydratisierungsmodul (506) mit einem Substrateingangsloch (515), durch das ein Substrat (501) ladbar ist und das einen Raum zum Montieren des Substrats (501) auf einem Träger (503) bereitstellt;
eine Ladeschleusenkammer (507), die mit dem Anti-Hydratisierungsmodul (506) verbunden ist und dazu ausgelegt ist, ein Vakuum aufrechtzuerhalten;
eine Vielzahl von Vakuumkammern (508a...508e), die mit der Ladeschleusenkammer (507) verbunden sind;
eine Abscheidekammer (509), die zwischen zweien der Vakuumkammern (508c, 508d) installiert ist;
eine Zieleinheit, die in der Abscheidekammer (509) installiert ist und dazu ausgelegt ist, ein Rohmaterial einer Schutzschicht auf dem Substrat (501) abzuscheiden;
eine Transfereinheit, die durchgehend in dem Anti-Hydratisierungsmodul (506), der Ladeschleusenkammer (507), den Vakuumkammern (508a...508e) und der Abscheidekammer (509) installiert ist und zum Transfer des auf dem Träger (503) montierten Substrats (501) ausgelegt ist; und
Schieberventile (504, 517...520), die in Grenzbereichen des Anti-Hydratisierungsmoduls (506), der Ladeschleusenkammer (507), der Vakuumkammern (508a...508e) und der Abscheidekammer (509) installiert sind und dazu ausgelegt sind, jedes des Anti-Hydratisierungsmoduls (506), der Ladeschleusenkammer (507), der Vakuumkammern (508a...508e) und der Abscheidekammer (509) selektiv zu öffnen oder schließen, **dadurch gekennzeichnet, dass**
das Anti-Hydratisierungsmodul (506) dazu ausgebildet ist, eine Inertgasatmosphäre aufrechtzuerhalten.

2. Die Vorrichtung nach Anspruch 1, ferner umfassend einen Schlitz (516), der zwischen dem Substrateingangsloch (515) und dem Anti-Hydratisierungsmodul (506) ausgebildet ist, dazu ausgelegt ist, durch eine Tür (513) selektiv geöffnet oder geschlossen zu werden, und einen Durchgang bereitstellt, durch den das Substrat (501) transferierbar ist.

3. Die Vorrichtung nach irgendeinem der vorhergehenden Ansprüche, wobei manche Vakuumkammern (508c, 508d) und die Abscheidekammer (509) durch einen Oben-Unten-Separator (511) in obere und untere Teile unterteilt sind.

4. Die Vorrichtung nach Anspruch 3, wobei Heizelemente (510) zum Aufheizen des Substrats (501) in manchen Vakuumkammern (508c, 508d) und der Abscheidekammer (509) installiert sind.

5. Die Vorrichtung nach irgendeinem der vorhergehenden Ansprüche, wobei die Zieleinheit eine Plasma- oder Elektronenstrahlquelle (522) sowie einen Herd (523) umfasst.

6. Die Vorrichtung nach irgendeinem der vorhergehenden Ansprüche, wobei die Transfereinheit Tragrollen (512a), die zum Transferieren des Trägers (503) ausgelegt sind, sowie Substratrollen (512b), die zum Transferieren des Substrats (501) ausgelegt sind, umfasst.

7. Die Vorrichtung nach Anspruch 6, wobei die Tragrollen (512a) kontinuierlich in dem Anti-Hydratisierungsmodul (506), der Ladeschleusenkammer (507), den Vakuumkammern (508a...508e) und der Abscheidekammer (509) angeordnet sind.

8. Die Vorrichtung nach Ansprüchen 6 oder 7, wobei die Substratrollen (512b) innerhalb des Anti-Hydratisierungsmoduls (506) installiert sind.

9. Die Vorrichtung nach Anspruch 8, wobei das Anti-Hydratisierungsmodul (506) eine Oben-Unten-Transfereinheit (514) umfasst, die dazu ausgelegt ist, die Tragrollen (512a) und die Substratrollen (512b) zu heben und zu senken.

10. Ein Verfahren zum Abscheiden einer Schutzschicht, wobei das Verfahren Folgendes umfasst:
Laden eines Substrats (501) durch ein Substrateingangsloch (515) in ein Anti-Hydratisierungsmodul (506);
Montieren des geladenen Substrats (501) auf einen Träger (503) durch Verwendung einer Oben-Unten-Transfereinheit (514);
Transferieren des auf dem Träger (503) montierten Substrats (501) zu einer Ladeschleusenkammer (507);
Führen des auf dem Träger (503) montierten Substrats (501) durch eine Vielzahl von Vakuumkammern (508a...508e);
Abscheiden einer Schutzschicht auf dem Substrat (501) durch Verwendung einer Zieleinheit einer Abscheidekammer (509) zwischen den Vakuumkammern (508a...508e); und
Aufnehmen des Substrats (501), in dem die Schutzschicht abgeschieden ist, nachdem das Substrat (501) die Vakuumkammern (508a...508e), die Ladeschleusenkammer (507) und das Anti-Hydratisierungsmodul (506) durchlaufen hat,
wobei das interne Anti-Hydratisierungsmodul (506) eine Inertgasatmosphäre aufrechterhält.

11. Das Verfahren nach Anspruch 10, wobei das Substrat (501) durch einen Schlitz (516), der zwischen dem Substrateingangsloch (515) und dem Anti-Hydratisierungsmodul (506) installiert ist, in das Anti-Hydratisierungsmodul (506) geladen wird.

12. Das Verfahren nach Ansprüchen 10 oder 11, wobei das Montieren des Substrats (501) auf den Träger (503) Folgendes umfasst:
Anheben des Trägers (503), der von Trägerrollen (512a) gestützt ist, in Richtung des Substrats (501);
Auflegen einer oberen Oberfläche des Trägers (503) auf eine untere Grenzoberfläche des Substrats (501);
Trennen von Substratrollen (512b), die das Substrat (501) stützen, von dem Substrat (501) durch Senken der Substratrollen (512b); und
Transferieren des Trägers (503), in dem das Substrat (501) montiert ist, durch Verwendung der Trägerrollen (512a).

13. Das Verfahren nach irgendeinem der Ansprüche 10 bis 12, ferner umfassend Anpassen von Druck der Ladeschleusenkammer (507) an Druck auf eine angrenzend verbundene Vakuumkammer (508a) durch Schließen eines Schieberventils (504), nachdem das auf dem Träger (503) montierte Substrat (501) transferiert wurde.

14. Das Verfahren nach irgendeinem der Ansprüche 10 bis 13, ferner umfassend Abscheiden von Feuchtigkeit des auf dem Träger (503) montierten Substrats (501), während das Substrat (501) einige Vakuumkammern (508c, 508d) und die zwischen den Vakuumkammern (508a...508e) installierte Abscheidekammer (509) durchläuft, durch Erhitzen von innerhalb der einigen Vakuumkammern (508c, 508d) und der Abscheidekammer (509) installierten Heizelementen (510).

15. Das Verfahren nach Anspruch 14, ferner umfassend Freisetzen von Feuchtigkeit, die von dem auf dem Träger (503) montierten und durch einen oberen Teil der einigen Kammern (508c, 508d) und der Abscheidekammer (509) geführten Substrat (501) abgeschieden wird, durch Installieren eines Oben-Unten-Separators (511) in den einigen Kammern (508c, 508d) und der Abscheidekammer (509).

16. Das Verfahren nach irgendeinem der Ansprüche 10 bis 15, wobei Feuchtigkeit unter Verwendung eines Vakuums von besagtem Substrat (501) und besagtem Träger (503) entfernt wird.

## Revendications

1. Appareil (500) pour déposer une couche protectrice, l'appareil (500) comprenant :
un module anti-hydratation (506) comportant un trou d'entrée de substrat (515) via lequel un substrat (501) peut être chargé et qui constitue un espace pour monter le substrat (501) sur un support (503) ;
une chambre de chargement-verrouillage (507), qui est reliée au module anti-hydratation (506) et conçue pour maintenir un vide ;
une pluralité de chambres à vide (508a...508e), qui sont reliées à la chambre de chargement-verrouillage (507) ;
une chambre de dépôt (509), qui est installée entre deux des chambres à vide (508c, 508d) ;
une unité cible, qui est installée dans la chambre de dépôt (509) et est conçue pour déposer une matière première d'une couche protectrice sur le substrat (501) ;
une unité de transfert qui est installée en continu dans le module anti-hydratation (506), la chambre de chargement-verrouillage (507), les chambres à vide (508a...508e), et la chambre de dépôt (509), et conçue pour le transfert du substrat (501) monté sur le support (503) ; et
des vannes-portes (504, 517...520), qui sont installées dans des contours du module anti-hydratation (506), la chambre de chargement-verrouillage (507), les chambres à vide (508a...508e), et la chambre de dépôt (509), et sont conçues pour ouvrir ou fermer sélectivement chacun des éléments consistant en le module anti-hydratation (506), la chambre de chargement-verrouillage (507), les chambres à vide (508a...508e), et la chambre de dépôt (509), **caractérisé en ce que** le module anti-hydratation (506) est formé de façon à maintenir une atmosphère de gaz inerte.

2. Appareil selon la revendication 1, comprenant, en outre, une fente (516), qui est formée entre le trou d'entrée de substrat (515) et le module anti-hydratation (506), est conçue pour être ouverte ou fermée sélectivement par une porte (513), et constitue un passage via lequel le substrat (501) peut être transféré.

3. Appareil selon l'une quelconque des revendications précédentes, dans lequel certaines chambres à vide (508c, 508d) et la chambre de dépôt (509) sont divisées en parties supérieure et inférieure par un séparateur supérieur et inférieur (511).

4. Appareil selon la revendication 3, dans lequel des dispositifs de chauffage (510) pour chauffer le substrat (501) sont installés dans certaines chambres à vide (508c, 508d) et la chambre de dépôt (509).

5. Appareil selon l'une quelconque des revendications précédentes, dans lequel l'unité cible comprend une source de plasma ou faisceau électronique (522) et un foyer (523).

6. Appareil selon l'une quelconque des revendications précédentes, dans lequel l'unité de transfert comprend des rouleaux de support (512a) qui sont conçus pour transférer le support (503), et des rouleaux de substrat (512b) qui sont conçus pour transférer le substrat (501).

7. Appareil selon la revendication 6, dans lequel les rouleaux de support (512a) sont situés en continu dans le module anti-hydratation (506), la chambre de chargement-verrouillage (507), les chambres à vide (508a...508e), et la chambre de dépôt (509).

8. Appareil selon la revendication 6 ou 7, dans lequel les rouleaux de substrat (512b) sont installés à l'intérieur du module anti-hydratation (506).

9. Appareil selon la revendication 8, dans lequel le module anti-hydratation (506) comprend une unité de transfert supérieure et inférieure (514), qui est conçue pour soulever et abaisser les rouleaux de support (512a) et les rouleaux de substrat (512b).

10. Procédé pour déposer une couche protectrice, le procédé comprenant les étapes consistant à :
charger un substrat (501) via un trou d'entrée de substrat (515) jusqu'à un module anti-hydratation (506) ;
monter le substrat (501) chargé sur un support (503) en utilisant une unité de transfert supérieure et inférieure (514) ;
transférer le substrat (501), monté sur le support (503), jusqu'à une chambre de chargement-verrouillage (507) ;
faire passer le substrat (501), monté sur le support (503), via une pluralité de chambres à vide (508a...508e) ;
déposer une couche protectrice sur le substrat (501) en utilisant une unité cible d'une chambre de dépôt (509) entre les chambres à vide (508a...508e) ; et
prélever le substrat (501), sur lequel est déposée la couche protectrice, une fois le substrat (501) passé via les chambres à vide (508a...508e), la chambre de chargement-verrouillage (507), et le module anti-hydratation (506),
où le module anti-hydratation (506) interne maintient une atmosphère de gaz inerte.

11. Procédé selon la revendication 10, dans lequel le substrat (501) est chargé dans le module anti-hydratation (506) via une fente (516), qui est installée entre le trou d'entrée de substrat (515) et le module anti-hydratation (506).

12. Procédé selon la revendication 10 ou 11, dans lequel le montage du substrat (501) sur le support (503) comprend les étapes consistant à :
soulever le support (503), qui est supporté par les rouleaux de support (512a), en direction du substrat (501) ;
étancher une surface supérieure du support (503) sur une surface limite inférieure du substrat (501) ;
séparer les rouleaux de substrat (512b), qui supportent le substrat (501), du substrat (501) en abaissant les rouleaux de substrat (512b) ; et
transférer le support (503), sur lequel est monté le substrat (501), en utilisant les rouleaux de support (512a).

13. Procédé selon l'une quelconque des revendications 10 à 12, comprenant, en outre, un ajustement de la pression de la chambre de chargement-verrouillage (507) en correspondance de la pression d'une chambre à vide (508a) reliée de manière adjacente en fermant une vanne-porte (504) une fois transféré le substrat (501), monté sur le support (503).

14. Procédé selon l'une quelconque des revendications 10 à 13, comprenant, en outre, un dépôt d'humidité du substrat (501), monté sur le support (503), tandis que le substrat (501) passe via certaines chambres à vide (508c, 508d) et la chambre de dépôt (509), installée entre les chambres à vide (508a...508e), par des rouleaux de chauffage (510) installés à l'intérieur de certaines chambres à vide (508c, 508d) et la chambre de dépôt (509).

15. Procédé selon la revendication 14, comprenant, en outre, une décharge d'humidité, qui est déposée du substrat (501), monté sur le support (503) et passant via une partie supérieure de certaines chambres (508c, 508d) et la chambre de dépôt (509), en installant un séparateur supérieur et inférieur (511) dans certaines chambres à vide (508c, 508d) et la chambre de dépôt (509).

16. Procédé selon l'une quelconque des revendications 10 à 15, dans lequel l'humidité est supprimée dudit substrat (501) et dudit support (503) en utilisant un vide.
